# EUROPEAN PATENT APPLICATION

(11) **EP 4 797 535 A1**
(43) Date of publication of application: **26.08.2026**
(21) Application number: 26156426.4
(22) Date of filing: 04.02.2026
(51) Int. Cl.: H03K 17/08, H02H 5/04

(54) **SYSTEMS AND METHODS FOR TEMPERATURE MONITORING OF POWER SWITCHING DEVICES**

(30) Priority: 20.02.2025 US 202519058663
(71) Applicant: GE Aviation Systems Limited, Bishops Cleeve Cheltenham Gloucestershire GL52 8SF (GB)
(72) Inventor: ROPER, Simon Edward, Cheltenham, GL52 8SF (GB); ATKINS, Joseph John, Cheltenham, GL52 8SF (GB)
(74) Representative: Openshaw & Co.

(57) **Abstract**

A system (200) and method for temperature monitoring of power switching devices are described herein. In some approaches, a system (200) for modelling a temperature rise within a transistor (204) with an integrated temperature sensing diode (206) includes a current source (214) and a control unit (216) (218). The current source (214) is configured to provide a current to the integrated temperature sensing diode (206). The control unit (216) (218) is operably coupled to the current source (214) and the integrated temperature sensing diode (206) and configured to receive a temperature dependent voltage signal, determine a temperature rise in the transistor (204) and output a trip signal (238) to turn off the transistor (204) based on the temperature rise.

## Description

### TECHNICAL FIELD

These teachings relate generally to power switching devices and more particularly to monitoring temperature in power switching devices.

### BACKGROUND

Solid state power controllers (SSPC) are used in many modern vehicle or aircraft applications. For example, these SSPCS can be used in aircraft to manage and switch current, voltage, and power between a voltage source and aircraft systems or components. Newer electrical systems may use higher voltages and currents, which may increase the likelihood of damage from overload and abnormal current conditions, reliability issues, and poor power quality. Accordingly, a system and method to prevent damage and improve reliability may be desirable.

### BRIEF DESCRIPTION OF DRAWINGS

Various needs are at least partially met through provision of the systems and methods for temperature monitoring of power switching devices described in the following detailed description, particularly when studied in conjunction with the drawings. A full and enabling disclosure of the aspects of the present description, including the best mode thereof, directed to one of ordinary skill in the art, is set forth in the specification, which refers to the appended figures, in which:
FIG. 1 comprises a schematic diagram of a protection system in accordance with various embodiments of these teachings;
FIG. 2 comprises a schematic diagram a protection system in accordance with various embodiments of these teachings; and
FIG. 3 comprises a schematic diagram a protection system in accordance with various embodiments of these teachings; and
FIG. 4 comprises a flow diagram for a method in accordance with various embodiments of these teachings.

Elements in the figures are illustrated for simplicity and clarity and have not necessarily been drawn to scale. For example, the dimensions and/or relative positioning of some of the elements in the figures may be exaggerated relative to other elements to help to improve understanding of various embodiments of the present teachings. Also, common but well-understood elements that are useful or necessary in a commercially feasible embodiment are often not depicted in order to facilitate a less obstructed view of these various embodiments of the present teachings. Certain actions and/or steps may be described or depicted in a particular order of occurrence while those skilled in the art will understand that such specificity with respect to sequence is not actually required.

### DETAILED DESCRIPTION

The systems and methods for temperature monitoring of power switching devices described herein provide approaches for monitoring a temperature rise in a transistor. More specifically, the system and methods described herein utilize a transistor with an integrated temperature sensing diode to monitor the temperature rise, thereby protecting the transistor from thermal stress and operation outside of its specification. The approaches described herein are advantageous for high-voltage, high-current applications, such as for aircraft applications.

Traditionally, a transistor includes a defined operating area that specifics the maximum power dissipation, current, and voltage of the device. Typically, a solid state power controller (SSPC) may implement a fast trip design. In such approaches, the allowable current is permitted to exceed a nominal rating several times until a threshold is surpassed. If the threshold is not met, due to a partial overcurrent events, or until the threshold is reached, the switching device may experience considerable thermal stress, which may impact reliability. Accordingly, the hardware protection system and method as described herein improves reliability, reduces the complexity and costs, and is scalable to high voltages, such as in aircraft applications.

In one embodiment, a system for monitoring a temperature rise within a transistor having an integrated temperature sensing diode includes a current source connected to the integrated temperature sensing diode to bias the integrated temperature sensing diode. A control unit is operably connected to the integrated temperature sensing diode to receive a temperature dependent voltage signal. The voltage drop across the integrated temperature sensing diode can be used to monitor the temperature in the transistor and control unit is configured to determine a temperature rise in the transistor and output a trip signal to turn off the transistor based on the temperature rise.

The terms and expressions used herein have the ordinary technical meaning as is accorded to such terms and expressions by persons skilled in the technical field as set forth above except where different specific meanings have otherwise been set forth herein. The word "or" when used herein shall be interpreted as having a disjunctive construction rather than a conjunctive construction unless otherwise specifically indicated. The terms "coupled," "fixed," "attached to," and the like refer to both direct coupling, fixing, or attaching, as well as indirect coupling, fixing, or attaching through one or more intermediate components or features, unless otherwise specified herein.

The singular forms "a", "an", and "the" include plural references unless the context clearly dictates otherwise.

As used herein, the term "off" refers to a reduction to a level considered as a leakage current of the transistor.

Approximating language, as used herein throughout the specification and claims, is applied to modify any quantitative representation that could permissibly vary without resulting in a change in the basic function to which it is related. Accordingly, a value modified by a term or terms such as "about", "approximately", and "substantially", are not to be limited to the precise value specified. In at least some instances, the approximating language may correspond to the precision of an instrument for measuring the value, or the precision of the methods or machines for constructing or manufacturing the components and/or systems. For example, the approximating language may refer to being within a 10 percent margin.

The foregoing and other benefits may become clearer upon making a thorough review and study of the following detailed description.

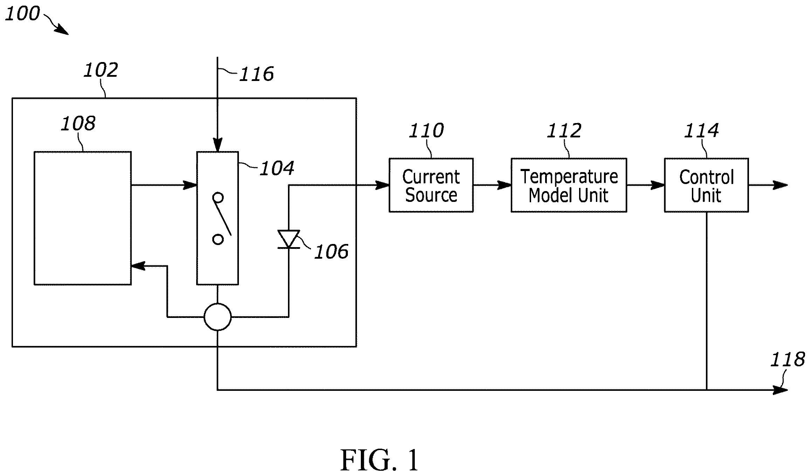

Referring now to the drawings, and in particular to FIG. 1, an example of a system 100 is described. The system 100 includes or has a transistor package 102 including a transistor 104 having an integrated temperature sensing diode 106 and a cell control unit 108, a current source 110, a temperature monitoring unit 112 and a control unit 114.

The transistor package 102, which may also be referred to as a transistor package, is configured to be connected between an electrical source 116 and an electrical load 118. In particular, the transistor 104 includes a source side connected to the electrical source 116 and a load side connected to the electrical load 118. In one form, it is contemplated that the transistor package 102 and the transistor 104 are for high voltage settings, such as, for example, in an aircraft electrical network with voltages in the range of about 28 Volts DC (VDC) to about 270VDC or greater. In some embodiments, a solid state power controller (SSPC) may contain one or more of the exemplary transistor package 102 shown in FIG. 1 for passing a current from the electrical source 116 to the electrical load 118.

The transistor 104 may comprise any of various types of transistors. In one preferred form, it is contemplated that a field effect transistor (FET) may be used, and in particular, a metal-oxide-semiconductor field-effect transistor (MOSFET). However, it should be understood that any of various types of transistors be used, such as, for example, without limitation, a bipolar junction transistor (BJT), an insulated gate bipolar transistor (IGBT) or any other switching device with a temperature sensor.

The integrated temperature sensing diode 106 is arranged to share the same thermal environment as the transistor 104. More specifically, the integrated temperature sensing diode 106 is integrated into the same transistor package 102 as the transistor 104. The integrated temperature sensing diode 106 outputs a temperature dependent voltage signal. As used herein, "temperature dependent voltage signal" refers to voltage level that varies in response to a change in temperature of the transistor 104. It is generally contemplated that a voltage drop (e.g., forward voltage) across the integrated temperature sensing diode 106 decreases as a temperature of the transistor 104 increases. Further, it is generally contemplated that the relationship between the voltage drop and the temperature may be linear or nonlinear.

The cell control unit 108 is operably coupled to the transistor 104 to supply a voltage and current to a gate terminal of the transistor 104 to turn or switch the transistor 104 on and off. For example, the cell control unit 108 may receive input, for example, from the control unit 114 or other components external to the system 100 and output a gate drive signal to turn the transistor 104 on or off. In some forms, the cell control unit 108 may measure and monitor a current flowing through the transistor 104. The cell control unit 108 may comprise, for example, a gate driver or any suitable gate driver circuit.

The current source 110 is connected electrically with the integrated temperature sensing diode 106 to bias the integrated temperature sensing diode 106. For example, the current source 110 provides a constant current to the integrated temperature sensing diode 106 such that the voltage drop across the integrated temperature sensing diode 106 changes linearly with the temperature of the transistor 104. The current source 110 may comprise, for example, a direct current (DC) current source.

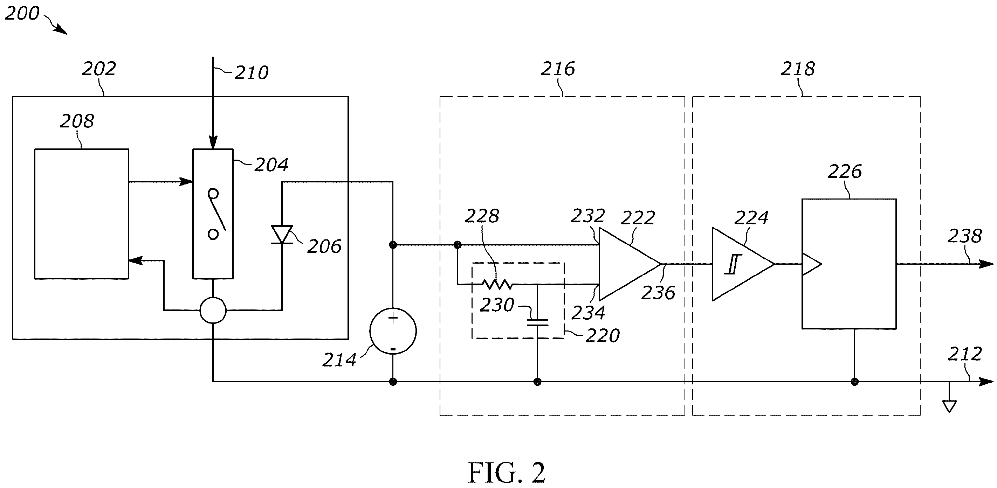

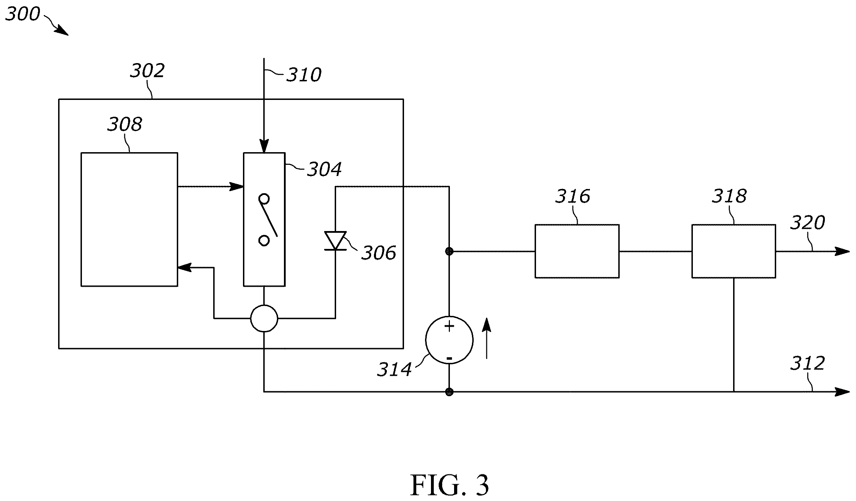

The temperature monitoring unit 112 is connected electrically to the integrated temperature sensing diode 106 to monitor a temperature rise in the transistor 104. More specifically, the temperature monitoring unit 112 measures the voltage drop or change in voltage over a predetermined interval across the integrated temperature sensing diode 106 to determine a temperature rise in the transistor 104. The temperature monitoring unit 112 comprises, for example, a low pass filter and a differential amplifier (e.g., as shown in FIG. 2), an analogue to digital converter (ADC) (e.g., as shown in FIG. 3), or any other suitable signal processing circuity.

The control unit 114 is operably connected to the temperature monitoring unit 112, and the cell control unit 108 to control a state of the transistor 104 based on the monitored temperature rise such that the transistor 104 is protected from thermal stress and operating outside of the predetermined specification. The control unit 114 comprises, for example, a trip comparator and latch (e.g., as shown in FIG. 2), or a digital controller (e.g., as shown in FIG. 3) or any other suitable processing device such as a microcontroller, a programmable logic device, a processor, a microprocessor, an application specific integrated circuit (ASIC), or a field-programmable gate array (FPGA).

Once the control unit 114 detects a temperature rise exceeding a predetermined threshold, the control unit 114 triggers a predetermined action to protect the transistor 104 from thermal stress and/or prevent the transistor 104 from operating outside the transistor specification. In other words, the control unit 114 triggers the predetermined action based on the monitored temperature rise of the temperature monitoring unit 112. The predetermined action may be in the form of transmitting a trip signal to turn off the transistor 104. The predetermined threshold may include a magnitude of the temperature rise in the range of about 30 to about 100 degrees or a rate of change of the temperature rise over a predetermined length of time or for any amount of time.

In one form, the control unit 114 may output a trip signal to turn off the transistor 104 when the temperature rise exceeds a predetermined threshold for any amount of time or for a certain period of time (such as, for example, 5 microseconds, 10 microseconds, 15 microseconds, etc.). In another form, the control unit 114 may output a trip signal to turn off the transistor 104 when the temperature rise exceeds a predetermined rate of change for any amount of time or for a certain period of time. In yet another form, the control unit 114 may output a trip signal to turn off the transistor 104 to limit the temperature rise over any amount of time or for a certain period of time to protect the transistor 104 from thermal stress.

Referring to FIG. 2, one example of a system 200 for monitoring a temperature rise in a transistor in accordance with various embodiments is provided. The system 200 includes or has a transistor package 202 including a transistor 204 having an integrated temperature sensing diode 206 and a cell control unit 208, a current source 214, and a temperature monitoring unit 216 and a control unit 218. The transistor package 202, transistor 204, integrated temperature sensing diode 206, cell control unit 208 and the current source 214 may be configured in substantially the same manner as described above in FIG. 1 and those descriptions will not be repeated here. Additionally, the temperature monitoring unit 216 may be an example of the temperature monitoring unit 112 as shown in FIG. 1 and the control unit 218 may be an example of the control unit 114 as shown in FIG. 1.

In the exemplary system 200 depicted in FIG. 2, the temperature monitoring unit 216 includes a low pass filter 220 and a differential amplifier 222 and the control unit 218 includes a comparator 224.

The low pass filter 220 comprises a n^{th} order low pass filter such as, for example, a 2^{nd} order filter or a 3^{rd} order filter including one or more resistors 228 and one or more capacitors 230. The low pass filter 220 is connected to the integrated temperature sensing diode 206 to measure the temperature dependent voltage and output a time-delayed temperature dependent voltage. In other words, the low pass filter 220 outputs a previous temperature of the transistor 104 based on the temperature dependent voltage from the integrated temperature sensing diode 206.

The differential amplifier 222 comprises a first input 232 connected to the low pass filter 220, a second input 234 connected to the integrated temperature sensing diode 206, and an output 236 connected to the comparator 224. The differential amplifier 222 receives the temperature dependent voltage at the first input 232 and the time-delayed temperature dependent voltage at the second input 234 and amplifies a difference thereof to output a signal representative of the temperature rise in the transistor 104 based on the voltage drop across the integrated temperature sensing diode 206. In this manner, the comparator 224 (e.g., differential amplifier 222) monitors the temperature rise in the transistor 204 based on a difference between a current temperature in the transistor 204 and a previous temperature in the transistor 204.

The output 236 of the differential amplifier 222 is connected to the comparator 224. The comparator 224 compares the output signal generated by the differential amplifier 222 representative of the temperature rise to a predetermined threshold (e.g., the output signal may be a temperature-dependent signal voltage signal). As described above, the predetermined threshold may include a magnitude of the temperature rise or a rate of change of the temperature rise. In some aspects, the comparator 224 compares the temperature rise in the transistor 104 to a predetermined threshold and outputs a trip signal 238 to the cell control unit 208 to turn off the transistor 204 when the temperature rise exceeds the predetermined threshold.

In some embodiments, the comparator 224 may output a latch trip signal to a digital storage device 226. The digital storage device 226 may comprise a latch mechanism, for example, a D (data or delay) latch, a flip flop (FF) latch or any suitable data storage device. The digital storage device 226 may receive the output latch trip signal from the comparator 224 and output the trip signal 238 to the cell control unit 208 to turn off the transistor 204. The digital storage device 226 ensures that a trip status (e.g. stores and holds the trip signal 238) of the transistor 104 is latched until a reset signal is received. The trip status (e.g., the trip signal 238) may be cleared by resetting the digital storage device 226 (e.g., the reset signal).

Referring to FIG. 3, another example of a system 300 for monitoring a temperature rise in the transistor in accordance with various embodiments is provided. The system 300 includes or has a transistor package 302 including a transistor 304 having an integrated temperature sensing diode 306 and a cell control unit 308, a current source 314, an analogue to digital converter (ADC) 316, and a control unit 318. The transistor package 302, transistor 304, integrated temperature sensing diode 306, cell control unit 308 and the current source 314 may be configured in substantially the same manner as described above in FIG. 1 and those descriptions will not be repeated here. Additionally, the analogue to digital converter (ADC) 316 may be an example of the temperature monitoring unit 112 as shown in FIG. 1 and the control unit 318 may be an example of the control unit 114 as shown in FIG. 1.

The ADC 316 is connected to the integrated temperature sensing diode 306 to sample the temperature dependent voltage signal. The ADC 316 may sample the temperature dependent voltage signal of the integrated temperature sensing diode 306 and convert the continuous analog signal into discrete digital signals. The digital signals from the ADC 316 is output to the control unit 318 to compute (e.g., monitor) a temperature rise in the transistor 304 over a predetermined period. The control unit 318 may comprise, for example, a digital controller or any other suitable processing device such as a microcontroller, a programmable logic device, a processor, a microprocessor, an application specific integrated circuit (ASIC), or a field-programmable gate array (FPGA).

The term "control unit" refers broadly to any microcontroller, computer, or processor-based device with processor, memory, and programmable input/output peripherals, alone or in combination, which is generally designed to govern the operation of other components and devices (for example, the cell control unit 308, the transistor 304). It is further understood to include common accompanying accessory devices, including external memory, transceivers for communication with other components and devices, etc. The control unit may be configured (for example, by using corresponding programming, instructions, and algorithms stored in a memory as will be well understood by those skilled in the art) to conduct one or more of the steps, actions, and/or functions described herein.

The control unit may include a memory and a network interface for accessing a wireless network(s). The memory can, for example, store non-transitorily computer instructions that cause the control unit to operate as described herein, when the instructions are executed. Further, the network interface may enable the control unit to communicate with other elements (both internal and external to the system). The network interface can communicatively couple the control unit to the wireless network. The control unit may make use of and/or operate in conjunction with databases. In some forms, the functionalities of the control unit may be implemented on a plurality of processor devices, such as, for example, communicating with one another on a network.

During operation, the control unit 318 processes the digital output of the ADC 316 to monitor and manage the thermal conditions of the transistor 304. In some aspects, the control unit 318 is configured to compute the temperature rise and output the trip signal 320 to turn off the transistor 304 when the temperature rise exceeds a predetermined threshold for a predetermined length of time. In other aspects, the control unit 318 is configured to compute the temperature rise and output the trip signal 320 to turn off the transistor 304 when the temperature rise exceeds a predetermined rate of change for a predetermined length of time or over any amount of time. In yet another aspect, the control unit 318 is configured to compute the temperature rise and output the trip signal 320 to turn off the transistor 304 to limit the temperature rise over a predetermined length of time to a predetermined value to protect the transistor 304 from thermal stress. Further, in another aspect, the control unit 318 is configured to compute the temperature rise and output the trip signal 320 to turn off the transistor 304 and after a predetermined period of time output a reset signal to turn on the transistor 304.

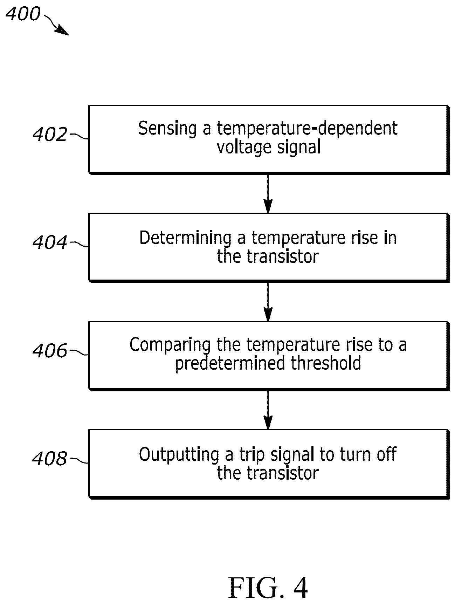

Referring to FIG. 4, a flow chart illustrating an exemplary method 400 for monitoring a temperature rise in a transistor in accordance with various embodiments is provided.

In block 402, the temperature monitoring unit (e.g., temperature monitoring unit 112 in FIG. 1) measures a temperature dependent voltage across an integrated temperature sensing diode (e.g., integrated temperature sensing diode 106 in FIG. 1) integrated in the transistor (e.g., transistor 104 in FIG. 1). In block 404, the temperature monitoring unit (e.g., temperature monitoring unit 112 in FIG. 1) determines a temperature rise in the transistor (e.g., transistor 104 in FIG. 1) based on the temperature dependent voltage across the integrated temperature sensing diode (e.g., integrated temperature sensing diode 106 in FIG. 1). In some aspects, the integrated temperature sensing diode (e.g., integrated temperature sensing diode 106 in FIG. 1) is biased with a constant current such that a voltage drop (e.g., forward voltage) across the integrated temperature sensing diode (e.g., integrated temperature sensing diode 106 in FIG. 1) is linearly correlated to an increase in temperature of the transistor (e.g., transistor 104).

In block 406, the control unit (e.g., control unit 114 in FIG. 1) compares the determined temperature rise in the transistor (e.g., transistor 104 in FIG. 1) to a predetermined threshold. If the determined temperature rise in the transistor (e.g., transistor 104 in FIG. 1) exceeds the predetermined threshold, in block 408, the control unit (e.g., control unit 114 in FIG. 1) outputs a trip signal to turn off the transistor (e.g., transistor 104 in FIG. 1). The trip signal is provided to a cell control unit (e.g., cell control unit 108 in FIG. 1) and the cell control unit (e.g., cell control unit 108 in FIG. 1) outputs a gate drive signal to turn the transistor 104 on or off.

Further aspects of the disclosure are provided by the subject matter of the following clauses:
A system for monitoring a temperature rise within a transistor, the transistor comprising an integrated temperature sensing diode, the system comprising: a current source electrically coupled to the integrated temperature sensing diode to provide a current to the integrated temperature sensing diode; and a control unit operably coupled to the current source and the integrated temperature sensing diode, the control unit configured to: receive a temperature dependent voltage signal; determine a temperature rise in the transistor based on the temperature dependent voltage signal; and output a trip signal to turn off the transistor based on the temperature rise.

The system of any preceding clause, wherein the current source is a direct current (DC) current source.

The system of any preceding clause, wherein the control unit is further configured to output the trip signal to turn off the transistor when the temperature rise exceeds a predetermined threshold.

The system of any preceding clause, wherein the control unit is further configured to output the trip signal to turn off the transistor when the temperature rise exceeds a predetermined threshold for a predetermined length of time.

The system of any preceding clause, wherein the control unit is further configured to output the trip signal to turn off the transistor when the temperature rise exceeds a predetermined rate of change.

The system of any preceding clause, wherein the control unit is further configured to output the trip signal to turn off the transistor to limit the temperature rise over a predetermined length of time to a predetermined value to protect the transistor from thermal stress.

The system of any preceding clause, wherein the control unit includes: a low pass filter connected to the integrated temperature sensing diode; and an amplifier including a first input connected to the low pass filter, a second input connected to the integrated temperature sensing diode, and a first output connected to a comparator.

The system of any preceding clause, wherein the amplifier is configured to amplify a difference between the temperature dependent voltage signal and a time-delayed temperature dependent voltage signal and generate an output signal based on the temperature rise in the transistor.

The system of any preceding clause, wherein the control unit further includes a comparator configured to compare the temperature rise to a predetermined threshold.

The system of any preceding clause, wherein the control unit further comprises a latch mechanism connected to the comparator and configured to output the trip signal to turn off the transistor when the temperature rise exceeds the predetermined threshold.

The system of any preceding clause, wherein the transistor is a metal-oxide-semiconductor field-effect transistor (MOSFET), a bipolar junction transistor (BJT), or an insulated gate bipolar transistor (IGBT).

A system for monitoring a temperature rise within a transistor, the transistor comprising an integrated temperature sensing diode, the system comprising: a current source electrically coupled to the integrated temperature sensing diode to provide a current to the integrated temperature sensing diode; and an analogue to digital converter (ADC) electrically coupled to the integrated temperature sensing diode; a processor configured to: receive digital signals from the ADC; compute a temperature rise in the transistor based on the digital signals; compare the computed temperature rise to a predetermined threshold; and output a trip signal to turn off the transistor when the computed temperature rise exceeds a predetermined threshold.

The system of any preceding clause, wherein the current source is a direct current (DC) current source.

The system of any preceding clause, wherein the processor is further configured to output the trip signal to turn off the transistor when the temperature rise exceeds a predetermined threshold for a predetermined length of time.

The system of any preceding clause, wherein the processor is further configured to output the trip signal to turn off the transistor when the temperature rise exceeds a predetermined rate of change.

The system of any preceding clause, wherein the processor is further configured to output the trip signal to turn off the transistor when the temperature rise exceeds a predetermined rate of change for a predetermined length of time.

The system of any preceding clause, wherein the processor is further configured to output the trip signal to turn off the transistor to limit the temperature rise over a predetermined length of time to a predetermined value to protect the transistor from thermal stress.

The system of any preceding clause, wherein the processor is further configured to output a reset signal to turn on the transistor after a predetermined length of time.

The system of any preceding clause, wherein the transistor is a metal-oxide-semiconductor field-effect transistor (MOSFET), a bipolar junction transistor (BJT) or an insulated gate bipolar transistor (IGBT).

A method for monitoring a temperature rise within a transistor, the transistor including an integrated temperature sensing diode, the method comprising: sensing a temperature-dependent voltage signal; determining a temperature rise in the transistor based on the temperature-dependent voltage signal; comparing the temperature rise in the transistor to a predetermined threshold; outputting a trip signal to turn off the transistor when the temperature rise exceeds a predetermined threshold.

The method of any preceding clause, further comprising providing a constant current to the integrated temperature sensing diode.

The method of any preceding clause, wherein outputting the trip signal further comprises outputting the trip signal to turn off the transistor when the temperature rise exceeds the predetermined threshold for a predetermined length of change.

The method of any preceding clause, wherein outputting the trip signal further comprises outputting the trip signal to turn off the transistor when the temperature rise exceeds a predetermined rate of change.

The method of any preceding clause, wherein outputting the trip signal further comprises outputting the trip signal to turn off the transistor to limit the temperature rise over a predetermined length of time to a predetermined value to protect the transistor from thermal stress.

The method of any preceding clause, further comprising outputting a reset signal to turn on the transistor after a predetermined length of time.

The method of any preceding clause, wherein the transistor is a metal-oxide-semiconductor field-effect transistor (MOSFET), a bipolar junction transistor (BJT), or an insulated gate bipolar transistor (IGBT).

## Claims

1. A system (200) for modelling a temperature rise within a transistor (204), the transistor (204) comprising an integrated temperature sensing diode (206), the system (200) comprising:
a current source (214) electrically coupled to the integrated temperature sensing diode (206) to provide a current to the integrated temperature sensing diode (206); and
a control unit (216)(218) operably coupled to the current source (110) and the integrated temperature sensing diode (106), the control unit (216)(218) configured to:
receive a temperature dependent voltage signal;
determine a temperature rise in the transistor (204) based on the temperature dependent voltage signal; and
output a trip signal (238) to turn off the transistor (204) based on the temperature rise.

2. The system of claim 1, wherein the control unit (216)(218) is configured to output the trip signal (238) to turn off the transistor (204) when the temperature rise exceeds a predetermined threshold.

3. The system of claim 1, wherein the control unit (216)(218) is configured to output the trip signal (238) to turn off the transistor (204) when the temperature rise exceeds a predetermined rate of change.

4. The system of claim 1, wherein the control unit (216)(218) is configured to output the trip signal (238) to turn off the transistor (204) to limit the temperature rise over a predetermined length of time to a predetermined value to protect the transistor (204) from thermal stress.

5. The system of any preceding claim, wherein the control unit (216)(218) includes:
a low pass filter (220) connected to the integrated temperature sensing diode (206); and
an amplifier (222) including a first input (234) connected to the low pass filter (220), a second input (232) connected to the integrated temperature sensing diode (206), and a first output (236) connected to a comparator (224).

6. The system of claim 5, wherein the amplifier (222) is configured to amplify a difference between the temperature dependent voltage signal and a time-delayed temperature dependent voltage signal and generate an output signal based on the temperature rise in the transistor (204).

7. The system of any preceding claim, wherein the control unit (216)(218) further includes a comparator (224) configured to compare the temperature rise to a predetermined threshold.

8. The system of claim 7, wherein the control unit (216)(218) further comprises a latch mechanism (226) connected to the comparator (224) and configured to output the trip signal (238) to turn off the transistor (204) when the comparator (224) detects that the temperature rise exceeds the predetermined threshold.

9. The system of any preceding claim, wherein the control unit (216)(218) includes an analogue to digital converter (ADC) (316) electrically coupled to the integrated temperature sensing diode (306) and a processor (318).

10. The system of claim 9, wherein the processor (318) is configured to:
receive digital signals from the ADC (316);
compute the temperature rise in the transistor (304) based on the digital signals;
compare the computed temperature rise to the predetermined threshold; and
output the trip signal (320) to turn off the transistor (304) when the computed temperature rise exceeds a predetermined threshold.

11. The system of claim 9, wherein the processor (318) is configured to output the trip signal (320) to turn off the transistor (304) when the temperature rise exceeds a predetermined rate of change.

12. The system of claim 9, wherein the processor (318) is configured to output the trip signal (320) to turn off the transistor (304) to limit the temperature rise over a predetermined length of time to a predetermined value to protect the transistor (304) from thermal stress.

13. The system of any of claims 9-12, wherein the processor (318) is further configured to output a reset signal to turn on the transistor (304) after a predetermined length of time.

14. The system of any preceding claim, wherein the transistor is a metal-oxide-semiconductor field-effect transistor (MOSFET), a bipolar junction transistor (BJT), or an insulated gate bipolar transistor (IGBT).

15. A method (400) for modelling a temperature rise within a transistor, the transistor including an integrated temperature sensing diode, the method comprising:
sensing (402) a temperature-dependent voltage signal;
determining (404) a temperature rise in the transistor based on the temperature-dependent voltage signal;
comparing (406) the temperature rise in the transistor to a predetermined threshold;
outputting (408) a trip signal to turn off the transistor when the temperature rise exceeds a predetermined threshold.
